# EUROPEAN PATENT APPLICATION

(11) **EP 1 970 978 A2**
(43) Date of publication of application: **17.09.2008**
(21) Application number: 08152670.9
(22) Date of filing: 13.03.2008
(51) Int. Cl.: H01L 51/54

(54) **Anthracene derivatives and organic light-emitting device including the same**

(30) Priority: 14.03.2007 KR 20070025072
(71) Applicant: Samsung SDI Co., Ltd., Suwon-si Gyeonggi-do (KR)
(72) Inventor: Choi, Kyung-Hoon, Seoul 135-875 (KR); Choi, Young-Suck, Suwon-si, Gyeonggi-do (KR); Park, Mie-Hwa, Suwon-si, Gyeonggi-do (KR); Lim, Choon-Woo, Suwon-si, Gyeonggi-do (KR); Chun, Min-Seung, Suwon-si, Gyeonggi-do (KR); Park, Young-Ho, Suwon-si, Gyeonggi-do (KR); Lee, Kwan-Hee, Suwon-si, Gyeonggi-do (KR)
(74) Representative: Hengelhaupt, Jürgen

(57) **Abstract**

Provided is an organic light-emitting device including: a first electrode; a second electrode; and one or more organic layers interposed between the first electrode and the second electrode. At least one of the organic layers includes one or more anthracene derivatives represented by Formula 1 below: 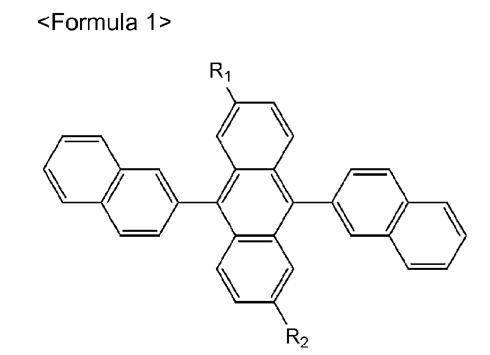 wherein R₁ and R₂ are each independently a hydrogen atom, a substituted or unsubstituted C1-C30 alkyl group, a substituted or unsubstituted C1-C30 alkoxy group, a substituted or unsubstituted C6-C30 aryl group, a substituted or unsubstituted C6-C30 aryloxy group, a substituted or unsubstituted C4-C30 heteroaryl group, a substituted or unsubstituted C6-C30 condensed polycyclic group, a hydroxyl group, halogen, a cyano group, or a substituted or unsubstituted amino group.

## Description

### Field of the Invention

The present invention relates to anthracene derivatives and an organic light-emitting device including the same. More particularly, the inventive organic light-emitting device has high efficiency, a low driving voltage, high brightness, and long lifetime, by virtue of using a material having electrical stability and good electron transport capability.

The present invention relates to a prerequisite technology for developing high-quality organic light-emitting devices which are improved in power consumption and lifetime characteristics.

### Description of the Related Art

Organic light-emitting devices are devices that emit light by recombination of electrons and holes in an organic layer interposed between two electrodes when a current is supplied to the organic layer. Organic light-emitting devices have advantages such as high image quality, a rapid response speed, and a wide viewing angle, and thus, can embody lightweight and thin information display apparatuses. By virtue of such advantages, the organic light-emitting device technology started to rapidly grow. Recently, the application field of organic light-emitting devices has expanded beyond mobile phones to other high-quality information display apparatuses.

With the rapid growth of organic light-emitting devices, the organic light-emitting devices should inevitably compete with other information display devices, such as TFT-LCDs. Conventional organic light-emitting devices are now facing technical limitations in terms of efficiency, lifetime, and power consumption of the devices which significantly affect quantitative and qualitative growth of the devices.

### SUMMARY OF THE INVENTION

The present invention provides an organic light-emitting device capable of enhancing lifetime, brightness, and power consumption efficiency.

According to an aspect of the present invention, there is provided an organic light-emitting device comprising: a first electrode; a second electrode; and one or more organic layers interposed between the first electrode and the second electrode, wherein at least one of the organic layers comprises one or more anthracene derivatives represented by Formula 1: 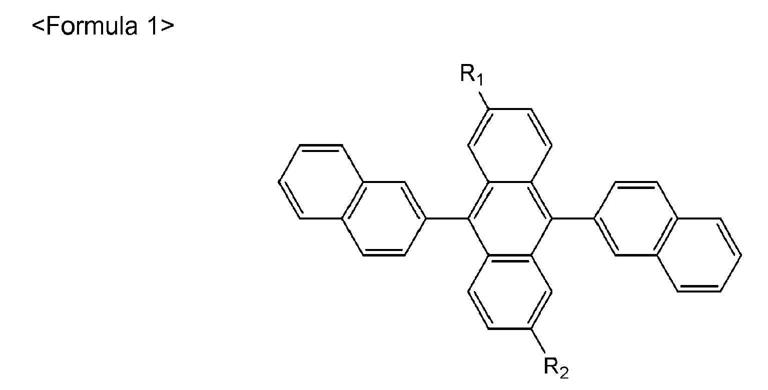 wherein R₁ and R₂ are each independently a hydrogen atom, a substituted or unsubstituted C1-C30 alkyl group, a substituted or unsubstituted C1-C30 alkoxy group, a substituted or unsubstituted C6-C30 aryl group, a substituted or unsubstituted C6-C30 aryloxy group, a substituted or unsubstituted C4-C30 heteroaryl group, a substituted or unsubstituted C6-C30 condensed polycyclic group, a hydroxyl group, halogen, a cyano group, or a substituted or unsubstituted amino group.

According to another aspect of the invention, there are provided the anthracene derivatives of Formula 1 as described above.

### BRIEF DESCRIPTION OF THE DRAWINGS

The above and other features and advantages of the present invention will become more apparent by describing in detail exemplary embodiments thereof with reference to the attached drawings in which:
FIGS. 1A through 1C are schematic sectional views illustrating organic light-emitting devices according to embodiments of the present invention;
FIG. 2 is a graph illustrating current densities of organic light-emitting devices manufactured in Examples 1-2 according to the present invention and Comparative Example 1;
FIG. 3 is a graph illustrating efficiency characteristics of the organic light-emitting devices manufactured in Examples 1-2 according to the present invention and Comparative Example 1; and
FIG. 4 is a graph illustrating lifetime characteristics of the organic light-emitting devices manufactured in Examples 1-2 according to the present invention and Comparative Example 1.

### DETAILED DESCRIPTION OF THE INVENTION

The present invention will now be described more fully with reference to the accompanying drawings, in which exemplary embodiments of the invention are shown.

The present invention provides an organic light-emitting device including: a first electrode; a second electrode; and one or more organic layers interposed between the first electrode and the second electrode.

At least one of the organic layers includes one or more anthracene derivatives represented by Formula 1 below and, optionally, an ionic metal complex: 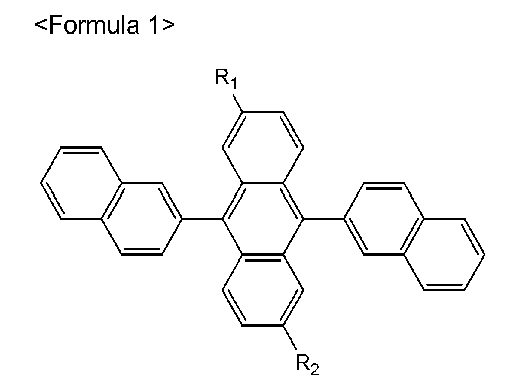 wherein R₁ and R₂ are each independently a hydrogen atom, a substituted or unsubstituted C1-C30 alkyl group, a substituted or unsubstituted C1-C30 alkoxy group, a substituted or unsubstituted C6-C30 aryl group, a substituted or unsubstituted C6-C30 aryloxy group, a substituted or unsubstituted C4-C30 heteroaryl group, a substituted or unsubstituted C6-C30 condensed polycyclic group, a hydroxyl group, halogen, a cyano group, or a substituted or unsubstituted amino group. For example, the organic layer may include an anthracene derivative compound represented by Formula 1 and an ionic metal complex or the organic layer may include two or more different anthracene derivatives represented by Formula 1.

Preferably, R₁ is hydrogen.

According to another preferred embodiment, in which preferably R₁ may also be hydrogen, R₂ is selected from the group consisting of a hydrogen atom, a C1-C4 alkyl group, a substituted or unsubstituted fluorenyl group, a substituted or unsubstituted anthracenyl group, a substituted or unsubstituted naphthyl group, a substituted or unsubstituted fluoranthenyl group, a substituted or unsubstituted perylenyl group, and an aryl substituted amino group.

According to another preferred embodiment, R₁ and/or R₂ is one selected from the group consisting of a phenyl group, a C1-C5 alkylphenyl group, a C1-C5 alkoxyphenyl group, a cyanophenyl group, a phenoxyphenyl group, a halophenyl group, a C1-C5 alkylnaphthyl group, a C1-C5 alkoxynaphthyl group, a cyanonaphthyl group, a halonaphthyl group, a carbazolyl group, a C1-C5 alkylcarbazolyl group, a biphenyl group, a C1-C5 alkylbiphenyl group, a C1-C5 alkoxybiphenyl group, and a pyridinyl group.

More preferably, R₁ and/or R₂ is one selected from the group consisting of a phenyl group, an ethylphenyl group, an ethylbiphenyl group, o-, m- and p-fluorophenyl groups, a dichlorophenyl group, a dicyanophenyl group, a trifluoromethoxyphenyl group, o-, m-, and p-tolyl groups, a mesityl group, a phenoxyphenyl group, a dimethylphenyl group, a (N,N'-dimethyl)aminophenyl group, a (N,N'-diphenyl)aminophenyl group, a pentalenyl group, a methylnaphthyl group, an azulenyl group, a heptalenyl group, an acenaphthylenyl group, an anthraquinolyl group, a phenanthryl group, a triphenylenyl group, a pentaphenyl group, a hexaphenyl group, and a carbazolyl group.

Examples of an unsubstituted C1-C20 alkyl group used in the formulae of the present invention include methyl, ethyl, propyl, isobutyl, sec-butyl, pentyl, iso-amyl, and hexyl. At least one hydrogen atom of the alkyl group may be substituted by a halogen atom, a hydroxy group, a nitro group, a cyano group, an amino group, an amidino group, hydrazine, hydrazone, a carboxyl group or its salt, a sulfonyl group or its salt, a phosphonyl group or its salt, a C1-C30 alkyl group, a C1-C30 alkenyl group, a C1-C30 alkynyl group, a C6-C30 aryl group, a C7-C30 arylalkyl group, a C2-C20 heteroaryl group, or a C3-C30 heteroarylalkyl group.

Examples of an unsubstituted C1-C20 alkoxy group used in the formulae of the present invention include methoxy, ethoxy, phenyloxy, cyclohexyloxy, naphthyloxy, isopropyloxy, and diphenyloxy. At least one hydrogen atom of the alkoxy group may be substituted by the same substituents as those recited in the above definition of the alkyl group.

An unsubstituted C6-C20 aryl group used in the formulae of the present invention, which is used alone or in combination, refers to an aromatic carbocyclic system containing one or more rings. The rings may be attached to each other as a pendant group or may be fused. At least one hydrogen atom of the aryl group may be substituted by the same substituents as those recited in the above definition of the alkyl group.

The aryl group may be a phenyl group, an ethylphenyl group, an ethylbiphenyl group, o-, m-, and p-fluorophenyl groups, a dichlorophenyl group, a dicyanophenyl group, a trifluoromethoxyphenyl group, o-, m-, and p-tolyl groups, o-, m-, and p-cumenyl groups, a mesityl group, a phenoxyphenyl group, a (α,α-dimethylbenzene)phenyl group, a (N,N'-dimethyl)aminophenyl group, a (N,N'-diphenyl)aminophenyl group, a pentalenyl group, an indenyl group, a naphthyl group, a methyl naphthyl group, an anthracenyl group, an azulenyl group, a heptalenyl group, an acenaphthylenyl group, a phenalenyl group, a fluorenyl group, an anthraquinolyl group, a methylanthryl group, a phenanthryl group, a triphenylene group, a pyrenyl group, a chrysenyl group, an ethyl-chrysenyl group, a picenyl group, a perylenyl group, a chloroperylenyl group, a pentaphenyl group, a pentacenyl group, a tetraphenylenyl group, a hexaphenyl group, a hexacenyl group, a rubicenyl group, a coronenyl group, a trinaphthylenyl group, a heptaphenyl group, a heptacenyl group, a pyranthrenyl group, an ovalenyl group, a carbazolyl group, etc.

Examples of an unsubstituted aryloxy group used in the formulae of the present invention include phenyloxy, naphthyleneoxy, and diphenyloxy. At least one hydrogen atom of the aryloxy group may be substituted by the same substituents as those recited in the above definition of the alkyl group.

An unsubstituted heteroaryl group used herein refers to a monovalent or divalent monocyclic or bicyclic aromatic organic compound of 6-30 carbon atoms containing one, two or three heteroatoms selected from N, O, P, and S. At least one hydrogen atom of the heteroaryl group may be substituted by the same substituents as those recited in the above definition of the alkyl group.

Examples of the heteroaryl group include a pyrazolyl group, an imidazolyl group, an oxazolyl group, a thiazolyl group, a triazolyl group, a tetrazolyl group, an oxadiazolyl group, a pyridinyl group, a pyridazinyl group, a pyrimidinyl group, a triazinyl group, a carbazolyl group, an indolyl group, etc.

Preferably, the compound of Formula 1 may be selected from compounds represented by Formulae 2 through 12 below:

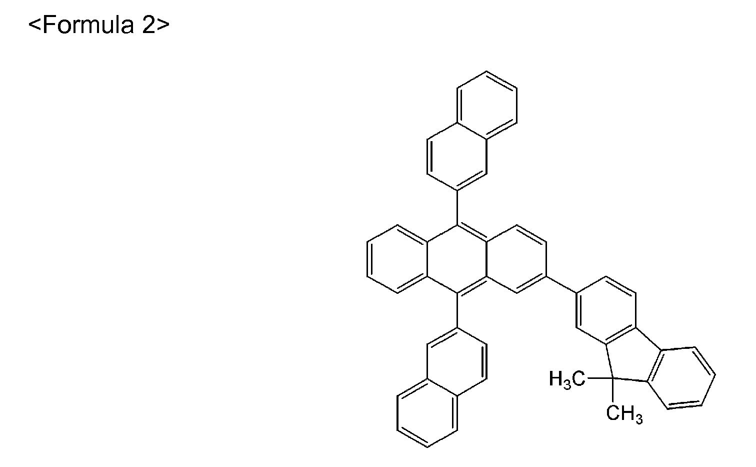

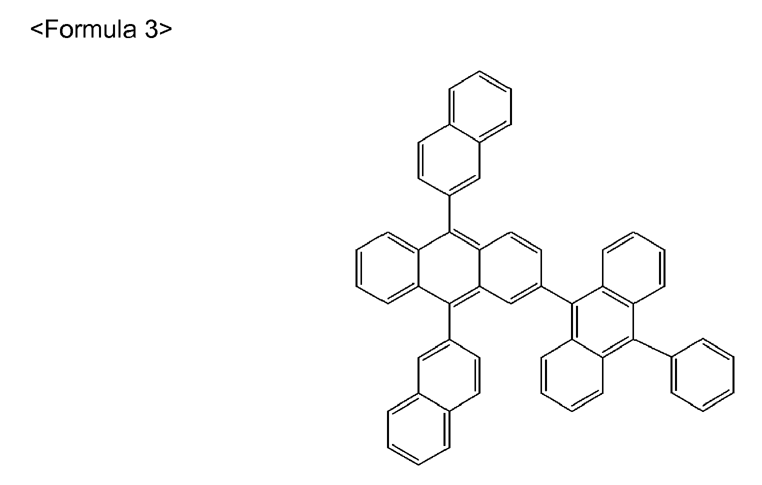

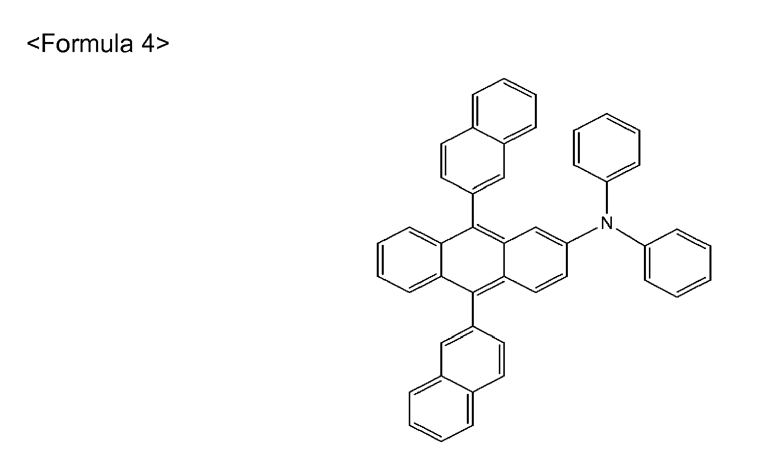

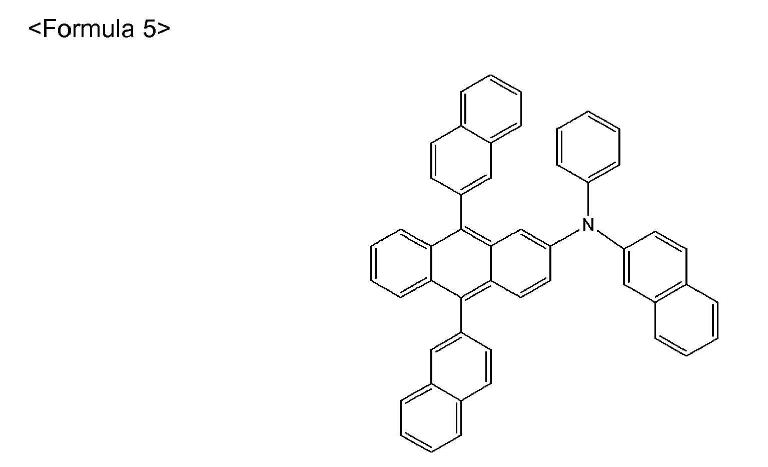

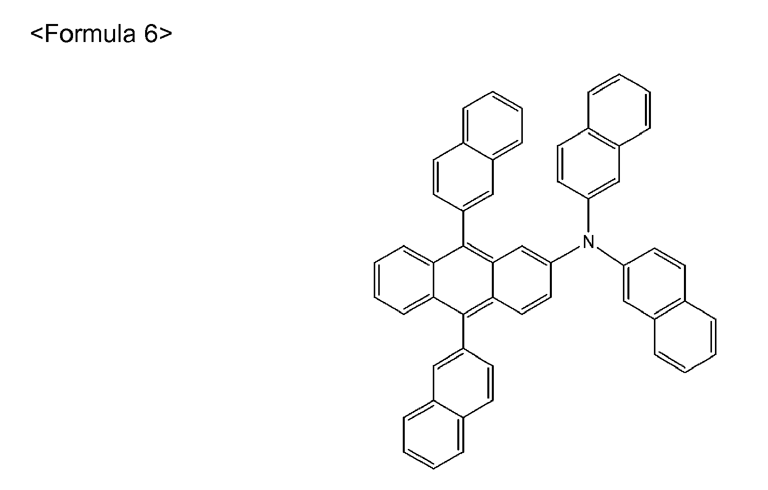

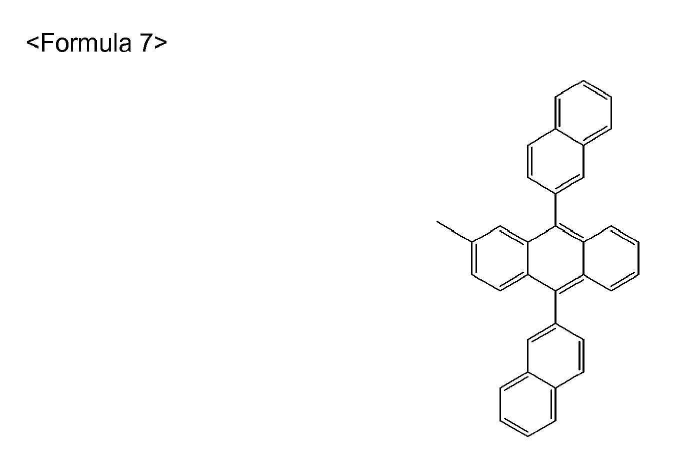

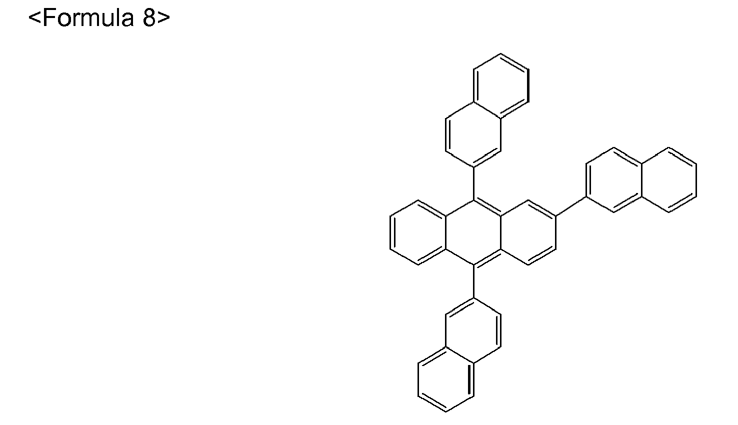

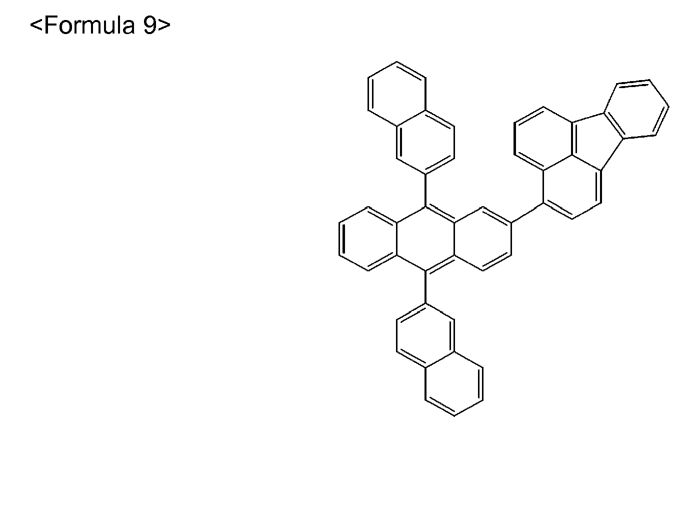

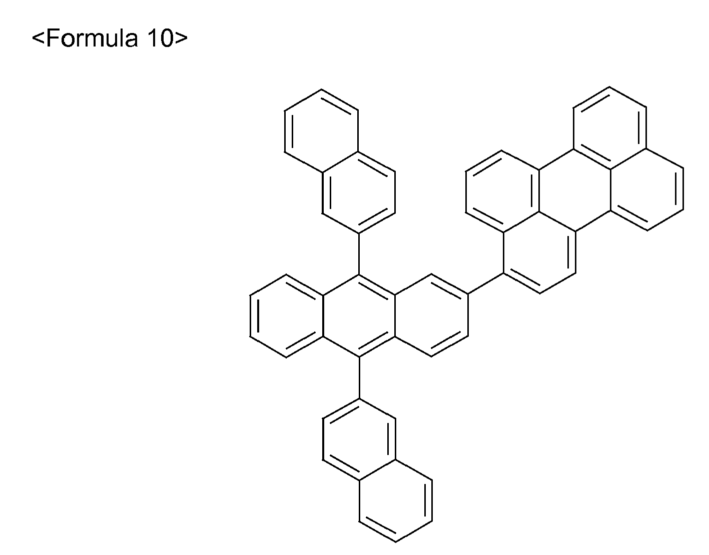

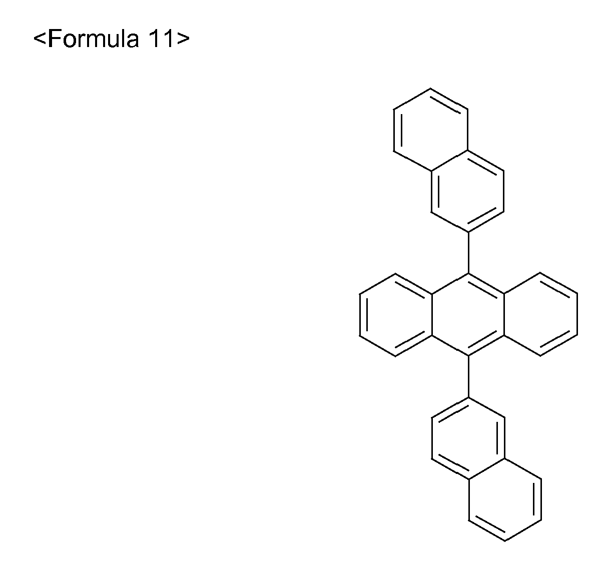

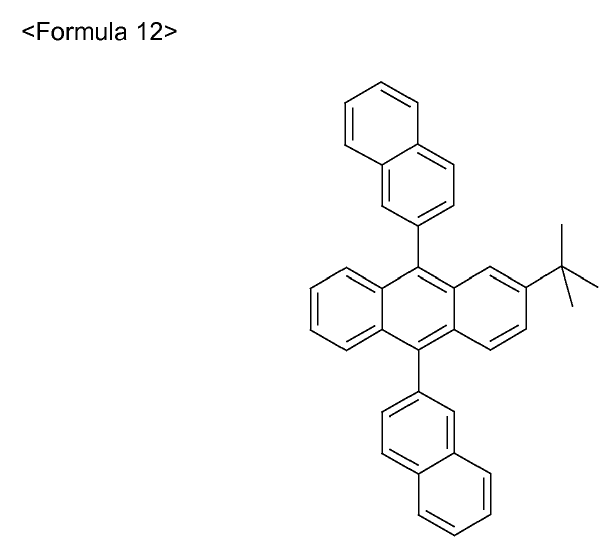

When the organic layer includes two or more different anthracene derivatives represented by Formula 1 above, those two or more different anthracene derivatives are preferably selected from the group consisting the compounds represented by Formulae 2through 12 above.

Preferably, the at least one organic layer comprising the anthracene derivative represented by Formula 1 further comprises an ionic metal complex. The ionic metal complex that can be used in the organic light-emitting device according to the present invention may be selected from compounds as represented by Formulae 13 through 15 below: 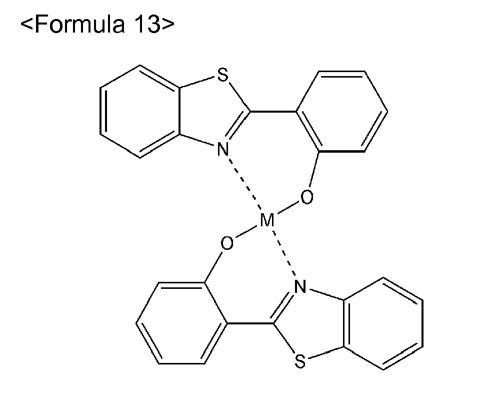 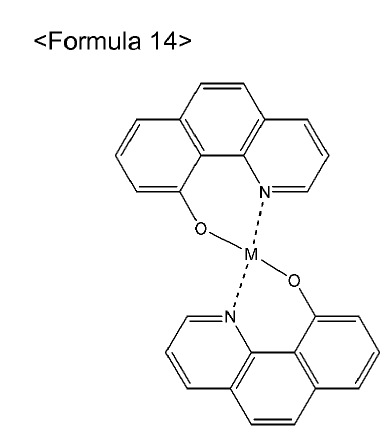 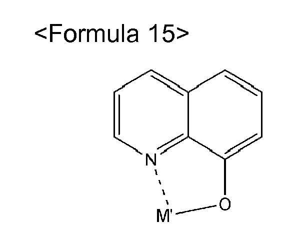 wherein M and M' are metals of an oxidation state (I) or (II).

For example, M and M' may be each ions of Li, Na, Ca, Cs, Be, Mg, Zn, or the like. More preferably, the ionic metal complex is a lithium quinolinolate (LiQ) metal complex, a sodium quinolinolate (NaQ) metal complex, or a cesium quinolinolate (CsQ) metal complex.

In the organic light-emitting device according to the present invention, a weight ratio of the anthracene derivative of Formula 1 and the ionic metal complex may be 5:95 to 95:5. If the weight ratio of the anthracene derivative of Formula 1 and the ionic metal complex is less than 5:95, i.e., if the content of the anthracene derivative of Formula 1 is too small, the lifetime of the organic light-emitting device may be reduced. On the other hand, if the weight ratio of the anthracene derivative of Formula 1 and the ionic metal complex exceeds 95:5, i.e., if the content of the ionic metal complex is too small, the driving voltage of the organic light-emitting device may be increased.

In the organic light-emitting device according to the present invention, a weight ratio of two different anthracene derivatives may be 5:95 to 95:5. If the content of one of the two different anthracene derivative is too high (greater than 95:5) or too low (less than 5:95), the lifetime of the organic light-emitting device may be reduced or a driving voltage may be increased.

The organic light-emitting device according to the present invention can be variously structured. The organic light-emitting device may further include at least one organic layer selected from the group consisting of an electron transport layer, an electron injection layer, a hole blocking layer, an emitting layer, an electron blocking layer, a hole injection layer, and a hole transport layer, between the first electrode and the second electrode. As described above, such an organic layer may include either a mixture of an anthracene derivative of Formula 1 and an ionic metal complex or a mixture of two or more different anthracene derivatives of Formula 1. Preferably, the organic layer may be an electron transport layer or an electron injection layer.

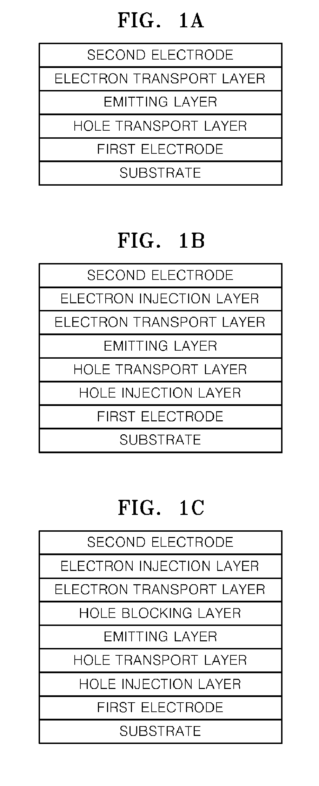

In more detail, organic light-emitting devices according to various embodiments of the present invention are illustrated in FIGS. 1A, 1B, and 1C. Referring to FIG. 1A, an organic light-emitting device has a first electrode/hole transport layer/emitting layer/electron transport layer/second electrode structure. Referring to FIG. 1B, an organic light-emitting device has a first electrode/hole injection layer/hole transport layer/emitting layer/electron transport layer/electron injection layer/second electrode structure. Referring to FIG. 1C, an organic light-emitting device has a first electrode/hole injection layer/hole transport layer/emitting layer/hole blocking layer/electron transport layer/electron injection layer/second electrode structure. Here, the emitting layer, the electron transport layer, or the electron injection layer may include an anthracene derivative of Formula 1.

Hereinafter, a method of manufacturing an organic light-emitting device according to an embodiment of the present invention will be described with reference to FIG. 1C.

First, a first electrode is formed on a substrate by deposition or sputtering using a first electrode material with a high work function. The first electrode may be an anode. Here, the substrate may be a substrate commonly used in organic light-emitting devices. Preferably, the substrate may be a glass or transparent plastic substrate which is excellent in mechanical strength, thermal stability, transparency, surface smoothness, handling property, and water repellency. The first electrode material may be a transparent material having good conductivity, e.g., indium tin oxide (ITO), indium zinc oxide (IZO), tin oxide (SnO₂), or zinc oxide (ZnO).

Next, a hole injection layer (HIL) may be formed on the first electrode using any one of various methods, e.g., vacuum deposition, spin-coating, casting, or Langmuir-Blodgett (LB) method.

When forming the hole injection layer using a vacuum deposition process, the deposition conditions vary according to the type of a hole injection layer material, the structure and thermal characteristics of the hole injection layer, etc. However, it is preferred that the hole injection layer should be deposited to a thickness of 10Å to 5 µm at a deposition rate of 0.01 to 100Å/sec, at a temperature of 100 to 500°C, and in a vacuum level of 10⁻⁸ to 10⁻³ torr.

The hole injection layer material is not particularly limited, and may be a phthalocyanine compound (e.g., copper phthalocyanine) disclosed in U.S. Pat. No. 4,356,429, a Starburst-type amine derivative (e.g., TCTA, m-MTDATA, m-MTDAPB) disclosed in Advanced Material, 6, p.677 (1994), or the like. Here, m-MTDATA is represented by the following formula:

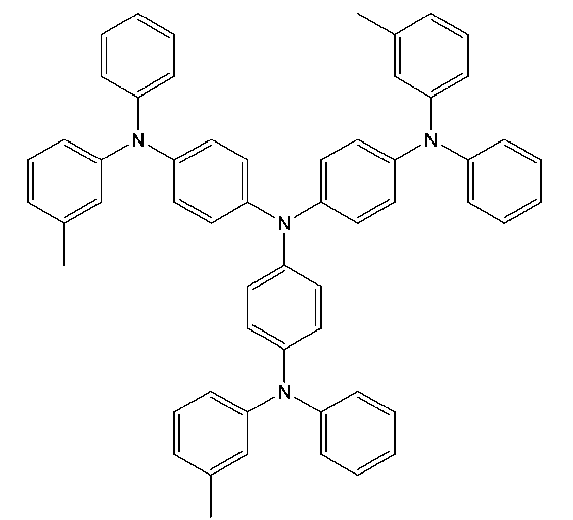

Next, a hole transport layer (HTL) may be formed on the hole injection layer using any one of various methods, e.g., vacuum deposition, spin-coating, casting, or LB method. When forming the hole transport layer using vacuum deposition, the deposition conditions vary according to the type of a used compound, but are generally almost the same as those used for the formation of the hole injection layer. A hole transport layer material is not particularly limited and may be optionally selected from known materials used in hole transport layers, e.g., a carbazole derivative such as N-phenylcarbazole or polyvinylcarbazole; an amine derivative having an aromatic fused ring such as N,N'-bis(3-methylphenyl)-N,N'-diphenyl-[1,1-biphenyl]-4,4'-diamine (TPD) or N,N'-di(naphthalene-1-yl)-N,N'-diphenylbenzidine (α-NPD); etc. Here, α-NPD is represented by the following formula:

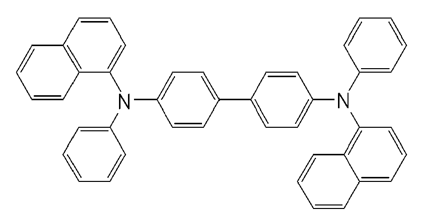

Next, an emitting layer (EML) may be formed on the hole transport layer using vacuum deposition, spin-coating, casting, LB method, or the like. When forming the emitting layer using vacuum deposition, the deposition conditions vary according to the type of a used compound, but are generally almost the same as those used for the formation of the hole injection layer.

An emitting material is not particularly limited and may be optionally selected from known emitting materials, known host materials, and known dopant materials. For example, a host material may be GGH01, GGH02, GDI1403 (Gracel Co., Ltd.), Alq₃, CBP (4,4'-N,N'-dicarbazole-biphenyl), or the like. As for a dopant, a fluorescent dopant may be GGD01, GGD02 (Gracel Co., Ltd.), C545T (Hayashibara Co., Ltd.), or the like, and a phosphorescent dopant may be a red phosphorescent dopant, e.g., PtOEP, RD25, RD61 (UDC), a green phosphorescent dopant, e.g., Ir(PPy)₃ (PPy=2-phenylpyridine), TLEC025, TLEC027 (Takasago Co., Ltd.), or a blue phosphorescent dopant, e.g., F2Irpic. Moreover, a dopant represented by the following formula may also be used:

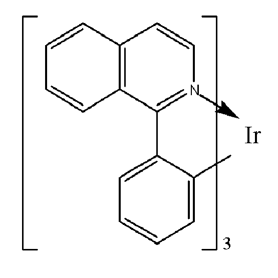

The doping concentration of the dopant is not particularly limited. Generally, the content of the dopant may be 0.01 to 15 parts by weight based on 100 parts by weight of the host and the dopant.

When the emitting layer includes a phosphorescent dopant, a hole blocking layer (HBL) may be further formed on the hole transport layer using vacuum deposition or spin-coating in order to prevent the diffusion of triplet excitons or holes into an electron transport layer. An available hole blocking material may be an oxadiazole derivative, a triazole derivative, a phenanthroline derivative, a hole blocking material disclosed in JP 11-329734(A1), BCP, or the like.

Next, an electron transport layer (ETL) is formed using any one of various methods, e.g., vacuum deposition, spin-coating, or casting. An electron transport layer material may be an anthracene derivative compound of Formula 1 capable of enhancing electron transport capability. The electron transport layer material may also be a known material, e.g., a quinoline derivative, in particular tris(8-quinolinolate)aluminum (Alq₃).

Preferably, the electron transport layer (ETL) is formed to a thickness of 5 to 70 nm. If the thickness of the electron transport layer is less than 5 nm, a balance between holes and electrons may not be maintained, thereby lowering efficiency. On the other hand, if it exceeds 70 nm, current characteristics may be lowered, thereby increasing a driving voltage.

Next, an electron injection layer (EIL) may be formed on the electron transport layer in order to facilitate the injection of electrons from a cathode. An electron injection layer material is not particularly limited.

The electron injection layer material may be LiF, NaCl, CsF, Li₂O, BaO, or the like. The deposition conditions of the hole blocking layer (HBL), the electron transport layer (ETL), and the electron injection layer (EIL) vary according to the types of used compounds, but are generally almost the same as those for the formation of the hole injection layer.

Finally, a second electrode may be formed on the electron injection layer using vacuum deposition or sputtering using a second electrode forming material. The second electrode may be used as a cathode. The second electrode forming material may be metal or alloy with a low work function, an electroconductive compound, or a mixture thereof. For example, the second electrode forming material may be lithium (Li), magnesium (Mg), aluminum (Al), aluminum-lithium (Al-Li), calcium (Ca), magnesium-indium (Mg-In), magnesium-silver (Mg-Ag), etc. The second electrode may also be a transmissive cathode formed of ITO or IZO to provide a front-emission type device.

An organic light-emitting device according to the present invention can be variously structured, in addition to a structure including a first electrode, a hole injection layer (HIL), a hole transport layer (HTL), an emitting layer (EML), a hole blocking layer (HBL), an electron transport layer (ETL), an electron injection layer (EIL), and a second electrode, as illustrated in FIG. 1C. When needed, one or two intermediate layers may be further formed.

Hereinafter, Synthesis Examples of a compound (hereinafter, referred to as "compound 2") represented by Formula 2 and a compound (hereinafter, referred to as "compound 3") represented by Formula 3 according to the present invention and

Examples will be described.

### Examples

### Synthesis Example 1

An intermediate A was synthesized according to Reaction Scheme 1 below.

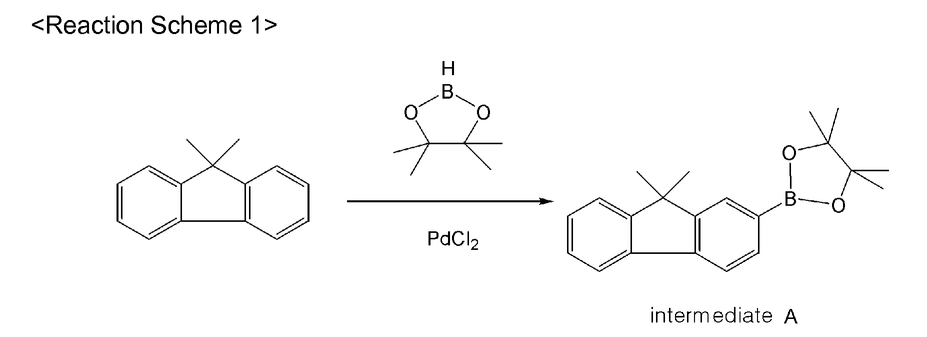

A compound 2 was synthesized using the intermediate A according to Reaction Scheme 2 below:

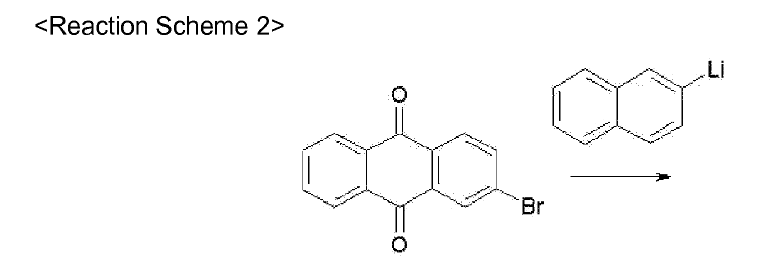

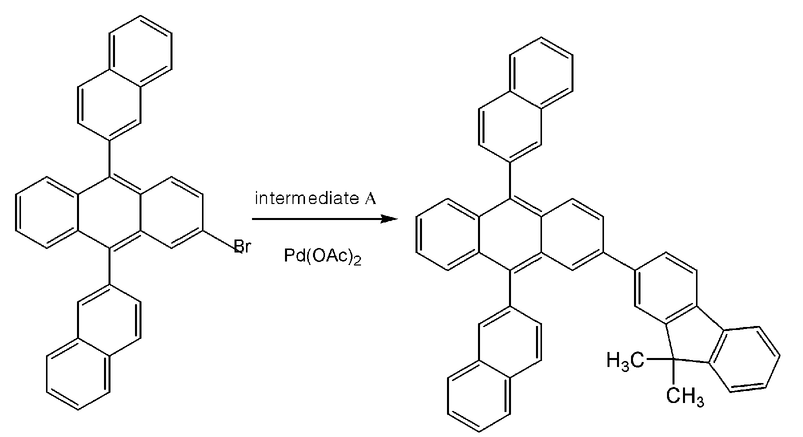

### Synthesis Example 2

An intermediate B was synthesized according to Reaction Scheme 3 below.

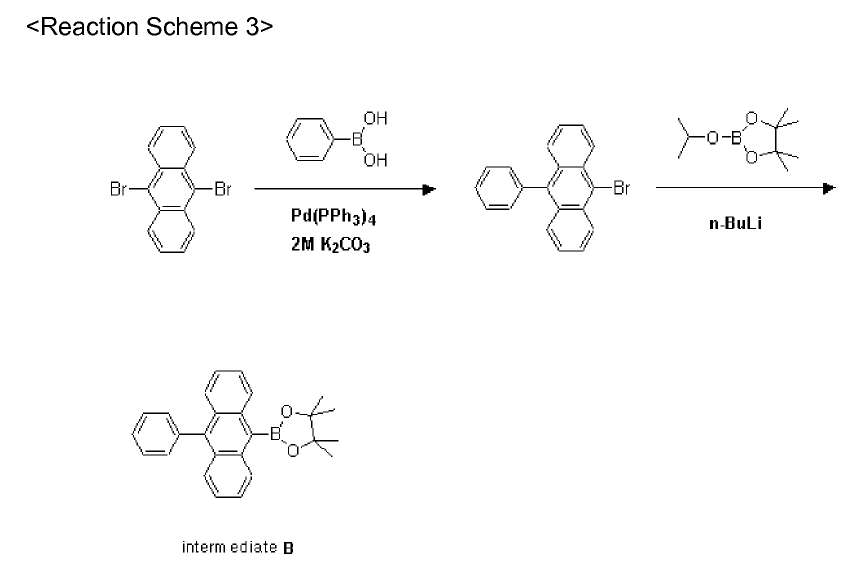

A compound 3 was synthesized according to Reaction Scheme 2 above using the intermediate B instead of the intermediate A.

### Example 1

Organic light-emitting devices having the following structure were manufactured using a mixture of the compound 2 synthesized in Synthesis Example 1 and sodium quinolinolate (NaQ) (weight ratio: 1:1) as an electron transport layer material: m-MTDATA(750Å)/α-NPD(150Å)/GBHO2(300Å):GBD32(3%)/electron transport layer (200Å)/LiQ(10Å)/Al(3000Å).

A 15 Ω/cm² ITO glass substrate (Corning, 1200) was cut into pieces of 50 mm x 50 mm x 0.7 mm in size, followed by ultrasonic cleaning in isopropyl alcohol and pure water (5 minutes for each) and UV/ozone cleaning (30 minutes) to form anodes. Then, m-MTDATA was vacuum-deposited to a thickness of 750Å on the anodes to form hole injection layers, and α-NPD was vacuum-deposited to a thickness of 150Å on the hole injection layers to form hole transport layers. Then, GBH02 (Gracel Co., Ltd.) as a blue fluorescent host and GBD32 (Gracel Co., Ltd.) as a dopant (weight ratio (%): 97:3) were vacuum-deposited to a thickness of 300Å on the hole transport layers to form emitting layers. Then, a mixture of the compound 2 and NaQ was vacuum-deposited to a thickness of 200Å on the emitting layers to form electron transport layers. LiQ (10Å, electron injection layers) and Al (3000Å, cathodes) were sequentially vacuum-deposited on the electron transport layers to form LiQ/Al electrodes. This completed the manufacture of organic light-emitting devices.

### Example 2

Organic light-emitting devices were manufactured in the same manner as in Example 1 except that a mixture of the compound 2 synthesized in Synthesis Example 1 and the compound 3 synthesized in Synthesis Example 2 (weight ratio: 1:1) was vacuum-deposited to form electron transport layers.

### Comparative Example 1

Organic light-emitting devices were manufactured in the same manner as in Example 1 except that Alq₃ was used as an electron transport layer material: m-MTDATA(750Å)/α-NPD(150Å)/GBHO2(300Å):GBD32(3%)/Alq₃(200Å)/LiF(80Å )/Al(3000Å).

### Evaluation Example 1

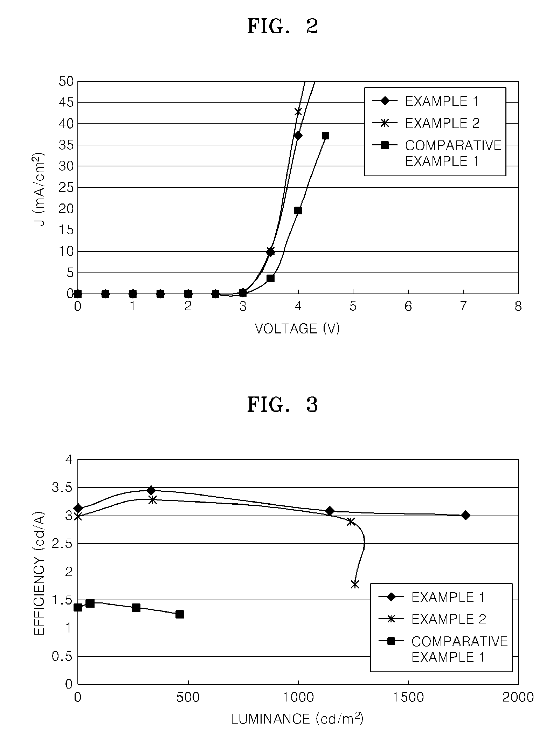

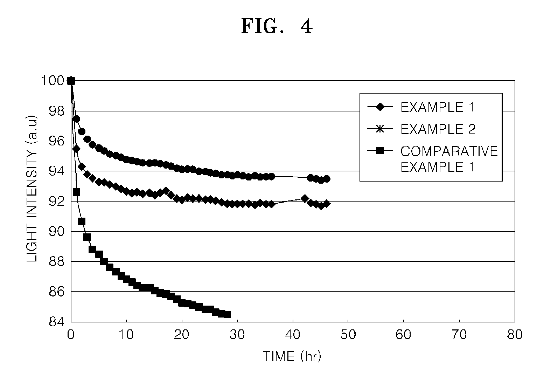

The current density, efficiency, and lifetime characteristics of the organic light-emitting devices manufactured in Examples 1-2 and Comparative Example 1 were evaluated. The graphs for the current density, efficiency, and lifetime characteristics are illustrated in FIGS. 2 through 4, respectively. The current density was evaluated using Source Measurement Unit 238 (Keithley), the efficiency characteristics were evaluated using PR650 (Photo Research Inc.), and the lifetime characteristics were evaluated using Polaronix M6000 (Mcscience).

It could be demonstrated that using a mixture of an anthracene derivative and an ionic metal complex or a mixture of two different anthracene derivatives in an organic light-emitting device improved the electron transport capability. Thus, the anthracene derivatives of Formula 1 can be efficiently used as an organic layer forming material. The organic light-emitting device with a respective organic layer has a high efficiency, a low driving voltage, high brightness, and a long lifetime.

## Claims

1. An organic light-emitting device comprising:
a first electrode;
a second electrode; and
one or more organic layers interposed between the first electrode and the second electrode, wherein at least one of the organic layers comprises one or more anthracene derivatives represented by Formula 1: 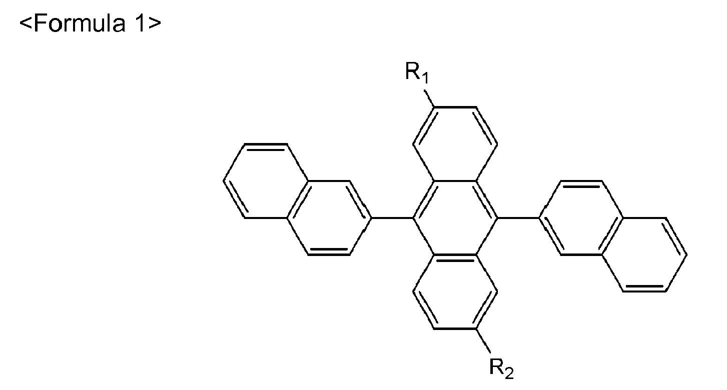
wherein R₁ and R₂ are each independently a hydrogen atom, a substituted or unsubstituted C1-C30 alkyl group, a substituted or unsubstituted C1-C30 alkoxy group, a substituted or unsubstituted C6-C30 aryl group, a substituted or unsubstituted C6-C30 aryloxy group, a substituted or unsubstituted C4-C30 heteroaryl group, a substituted or unsubstituted C6-C30 condensed polycyclic group, a hydroxyl group, halogen, a cyano group, or a substituted or unsubstituted amino group.

2. The organic light-emitting device of claim 1, wherein R₁ is hydrogen.

3. The organic light-emitting device of claim 1 or claim 2, wherein R₂ is selected from the group consisting of a hydrogen atom, a C1-C4 alkyl group, a substituted or unsubstituted fluorenyl group, a substituted or unsubstituted anthracenyl group, a substituted or unsubstituted naphthyl group, a substituted or unsubstituted fluoranthenyl group, a substituted or unsubstituted perylenyl group, and an aryl substituted amino group.

4. The organic light-emitting device of claim 3, wherein the anthracene derivative of Formula 1 is one selected from compounds represented by Formulae 2 through 12 below:

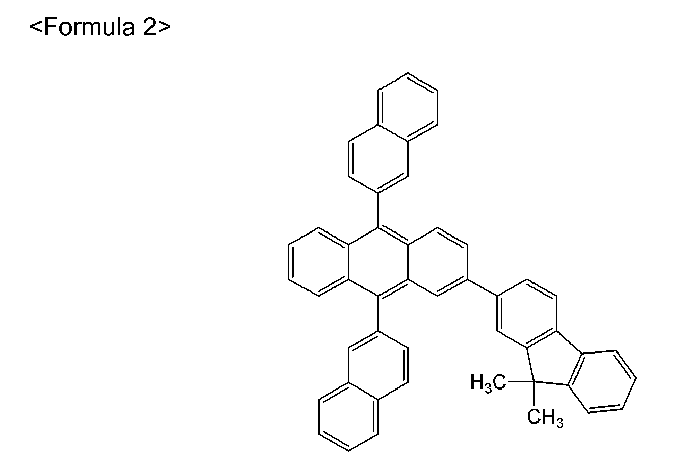

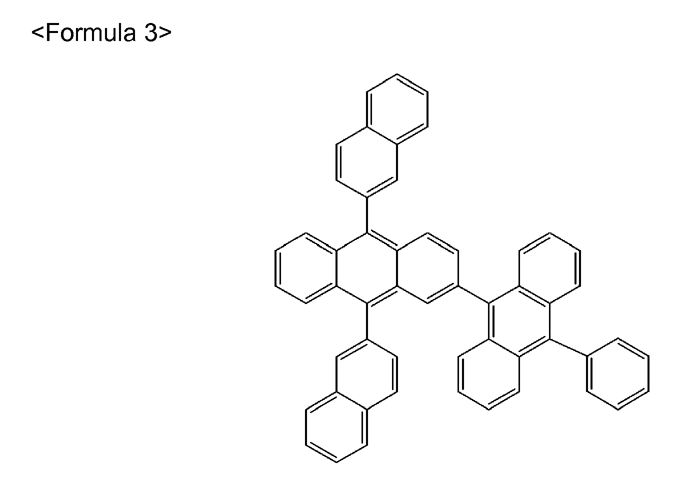

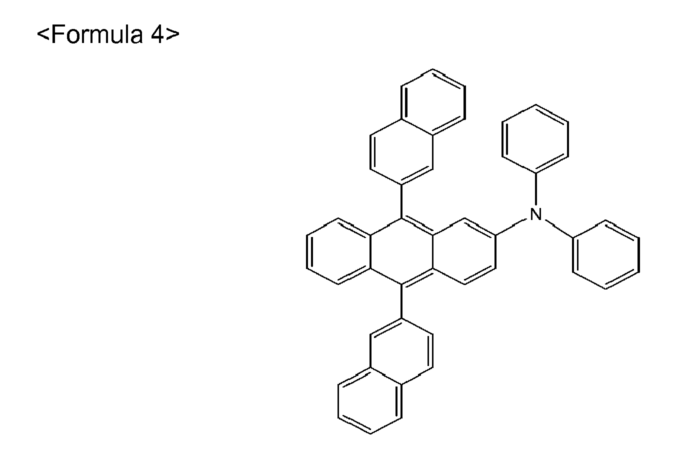

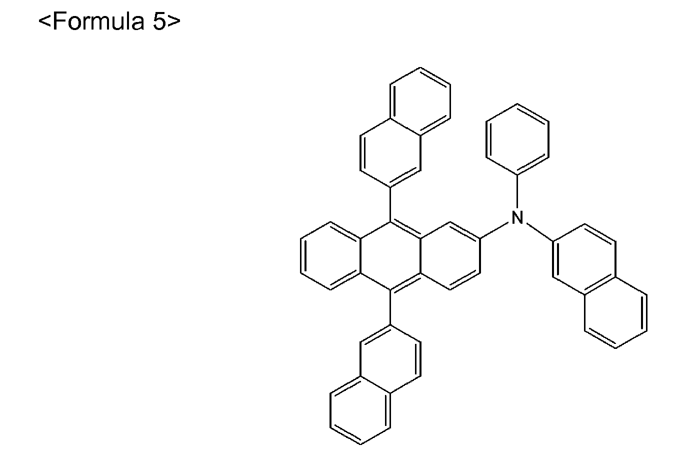

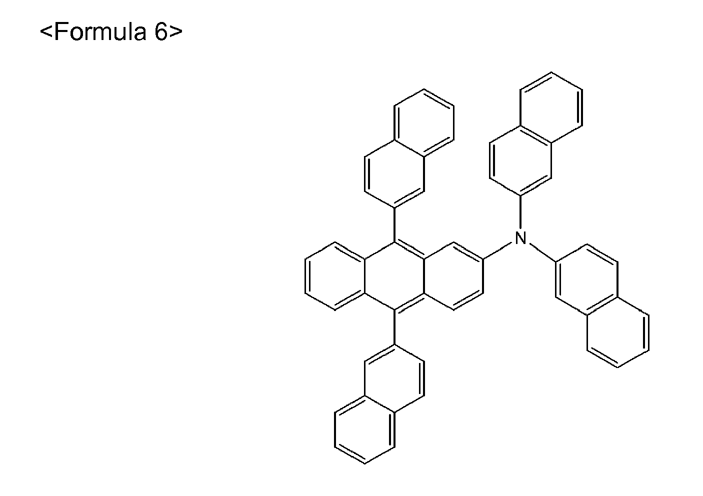

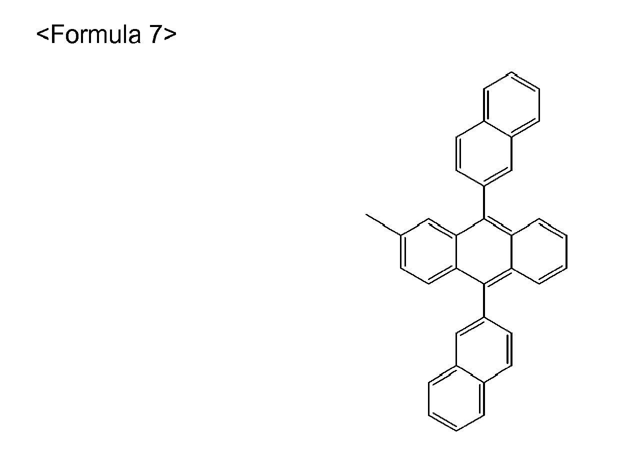

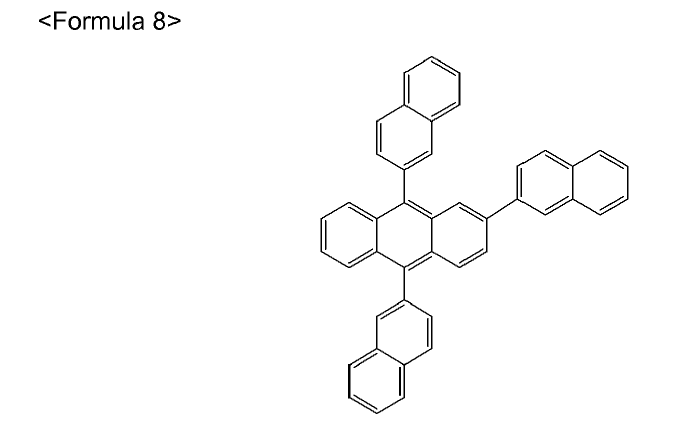

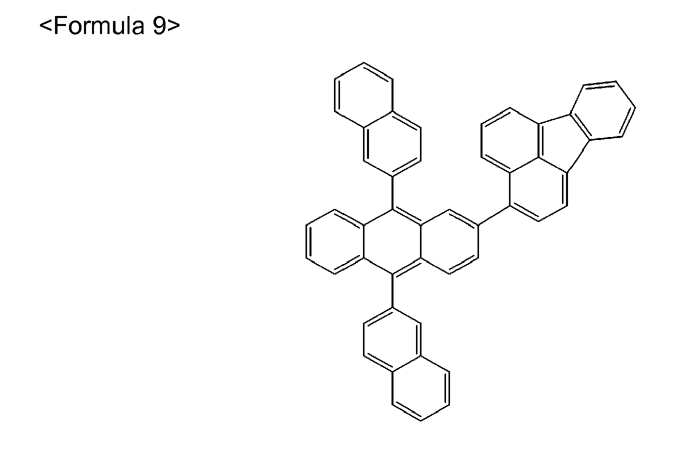

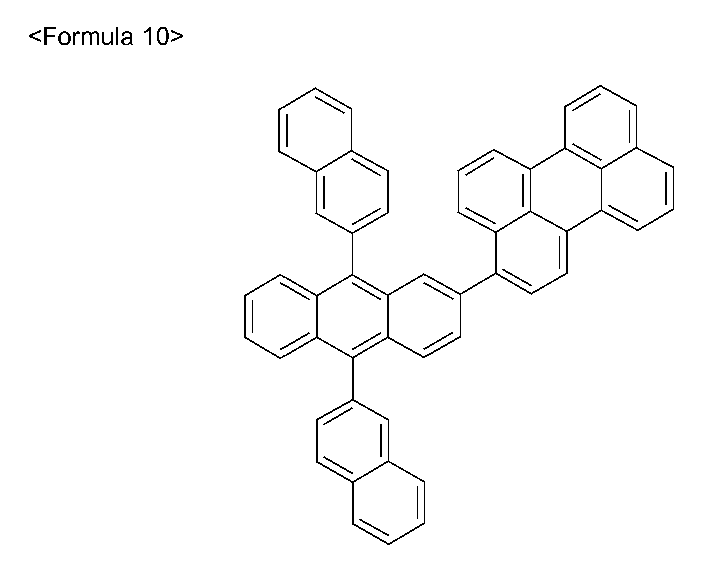

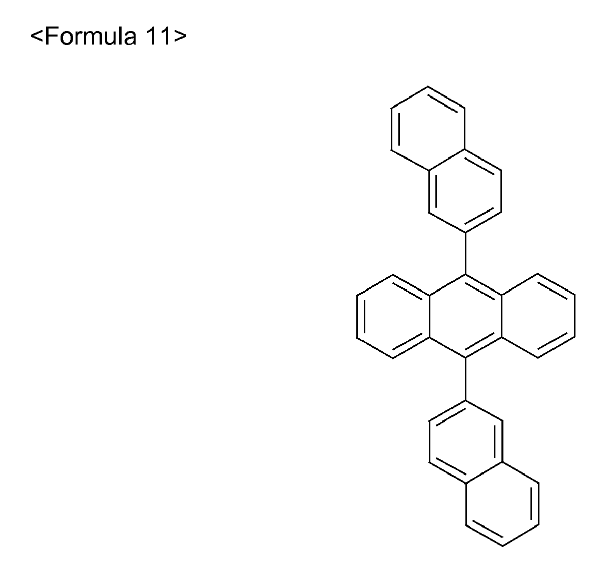

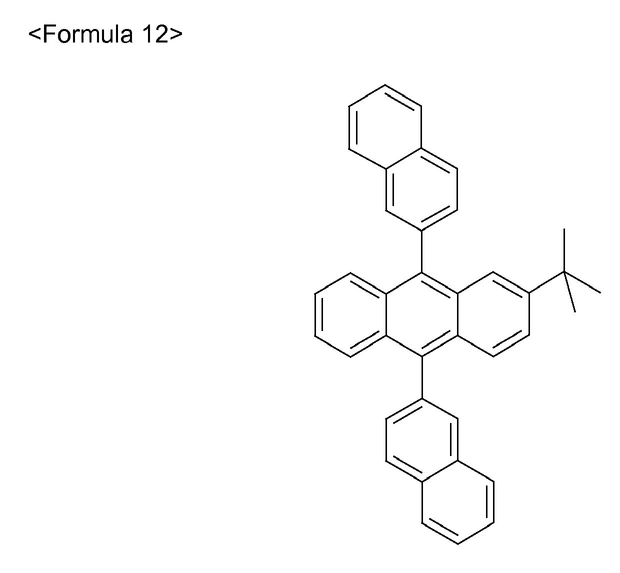

5. The organic light-emitting device of claim 1, wherein R₁ and/or R₂ is one selected from the group consisting of a phenyl group, a C1-C5 alkylphenyl group, a C1-C5 alkoxyphenyl group, a cyanophenyl group, a phenoxyphenyl group, a halophenyl group, a C1-C5 alkylnaphthyl group, a C1-C5 alkoxynaphthyl group, a cyanonaphthyl group, a halonaphthyl group, a carbazolyl group, a C1-C5 alkylcarbazolyl group, a biphenyl group, a C1-C5 alkylbiphenyl group, a C1-C5 alkoxybiphenyl group, and a pyridinyl group.

6. The organic light-emitting device of claim 5, wherein R₁ and/or R₂ are each independently one selected from the group consisting of a phenyl group, an ethylphenyl group, an ethylbiphenyl group, o-, m- and p-fluorophenyl groups, a dichlorophenyl group, a dicyanophenyl group, a trifluoromethoxyphenyl group, o-, m-, and p-tolyl groups, a mesityl group, a phenoxyphenyl group, a dimethylphenyl group, a (N,N'-dimethyl)aminophenyl group, a (N,N'-diphenyl)aminophenyl group, a pentalenyl group, a methyl naphthyl group, an azulenyl group, a heptalenyl group, an acenaphthylenyl group, an anthraquinolyl group, a phenanthryl group, a triphenylenyl group, a pentaphenyl group, a hexaphenyl group, and a carbazolyl group.

7. An organic light-emitting device of any of the preceding claims, wherein the at least one organic layer comprising the anthracene derivative represented by Formula 1 further comprises an ionic metal complex.

8. The organic light-emitting device of claim 7, wherein the ionic metal complex is a compound represented by Formula 13, 14, or 15 below: 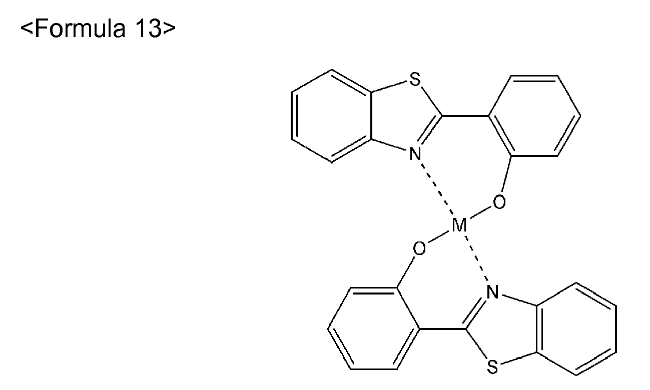 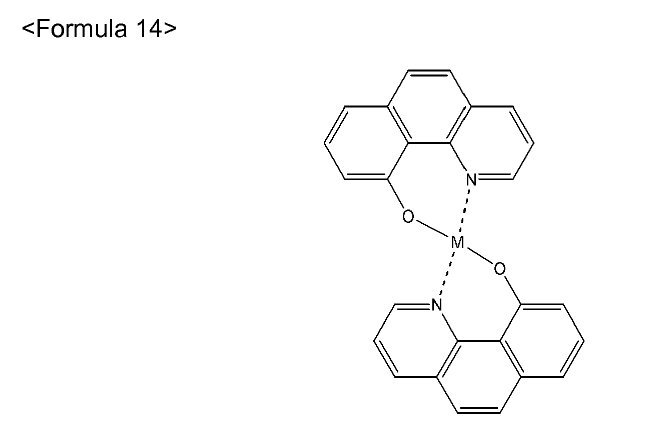 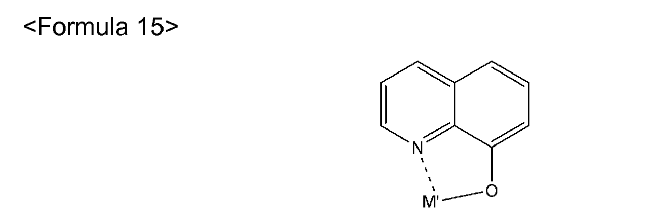 wherein M and M' are metals of an oxidation state (I) or (II).

9. The organic light-emitting device of claim 1, wherein the organic layer includes a compound represented by Formula 2 and sodium quinolinolate (NaQ).

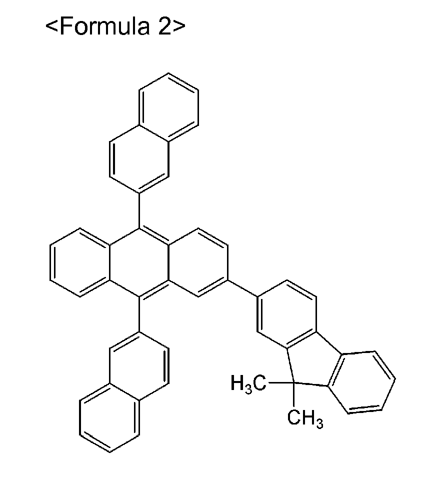

10. The organic light-emitting device of any of claims 7 to 9, wherein a weight ratio of the anthracene derivative and the ionic metal complex is 5:95 to 95:5.

11. The organic light-emitting device of claim 1, wherein the organic layer includes compounds represented by Formulae 2 and 3.

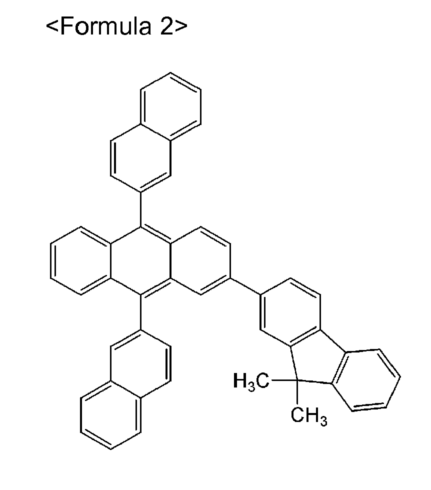

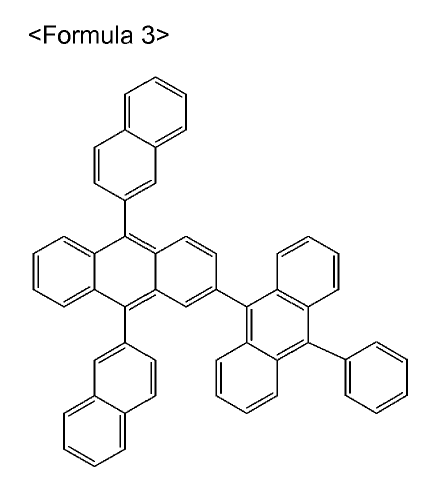

12. The organic light-emitting device of any of claims 1 through 6 and 11, wherein the organic layer comprises two different anthracene derivatives represented by Formula 1 and a weight ratio of the two different anthracene derivatives is 5:95 to 95:5.

13. The organic light-emitting device of any of the preceding claims, wherein the organic layer is an electron transport layer or an electron injection layer.

14. An anthracene derivatives represented by Formula 1: 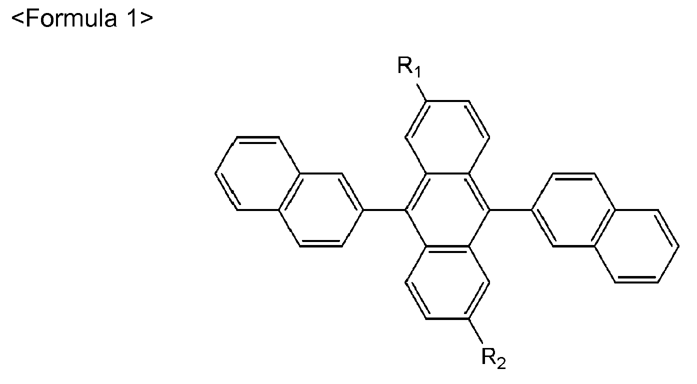 wherein R₁ and R₂ are each independently a hydrogen atom, a substituted or unsubstituted C1-C30 alkyl group, a substituted or unsubstituted C1-C30 alkoxy group, a substituted or unsubstituted C6-C30 aryl group, a substituted or unsubstituted C6-C30 aryloxy group, a substituted or unsubstituted C4-C30 heteroaryl group, a substituted or unsubstituted C6-C30 condensed polycyclic group, a hydroxyl group, halogen, a cyano group, or a substituted or unsubstituted amino group.
